Europäisches Patentamt

European Patent Office

Office européen des brevets

(11) Publication number: **0 090 519**
**A2**

## (12) EUROPEAN PATENT APPLICATION

(21) Application number: **83301230.5**

(22) Date of filing: **08.03.83**

(51) Int. Cl.³: **H 05 K 13/00**

(30) Priority: **27.03.82 GB 8209067**

(43) Date of publication of application: **05.10.83**
Bulletin 83/40

(84) Designated Contracting States: **AT BE CH DE FR GB IT LI LU NL SE**

(71) Applicant: **BURNDEPT ELECTRONICS LIMITED, St. Fidelis Road, Erith Kent DA8 1AU (GB)**

(72) Inventor: **Hilsden, John Sidney, 24 Lodge Avenue, Dartford Kent DA1 3DX (GB)**

(74) Representative: **Oliver, Roy Edward et al, POLLAK, MERCER & TENCH High Holborn House 52-54 High Holborn, London WC1V 6RY (GB)**

(54) **Container.**

(57) A storage container (1), particularly for storing electronic components during the assembly of electronic circuits, comprising a main receptacle housing (2) and a plurality of storage compartments defined therein, at least one pair of adjacent compartments being separated by a divider (6) which is moveable with respect to the main receptacle housing (2), whereby each of said at least one pair of adjacent compartments is adjustable in size. In a preferred embodiment, the main receptacle housing (2) is elongate and generally U-shaped in cross-section and the or each divider (6) is correspondingly U-shaped and is adjustably moveable axially with respect to the longitudinal axis of the housing (2). The or each divider (6) may be fixed at a required position along the length of the axis of the housing (2).

-1-

CONTAINER

DESCRIPTION

This invention relates to containers for storing and/or transporting articles, such as, electrical components, and is especially, but not exclusively related to such containers for controlling the work in progress (WIP) in the assembly and batch production of small electronic products, for instance, printed circuit board (PCB) modules.

It will be appreciated that if, during the batch production of PCB modules, the work in progress, that is to say, the quantity of different electronic components for assembling the modules at any one time on an assembly shop floor, is maintained at a minimum to provide, say, one day's output, then stock levels of the components can also be kept at a minimum. This method of batch production is in contrast to known production methods wherein the operative at each assembly station is provided with large numbers of each component and is required to assemble one or more different types of module over a comparatively long period of, say, two-four weeks. The components are usually kept in an assembly station during this period in open trays in a somewhat untidy manner, this arrangement increasing the possibility of components being transferred to the wrong tray and/or being completely lost or damaged. This arrangement also results in large component stocks having to be maintained.

Alternatively, other known assembly methods employ semi-automatic, carousel - type component containers which can be programmed to provide access to each component tray by an operative at a predetermined time in each assembly operation. However, these semi-automatic container systems are expensive to buy and to maintain and, on breakdown or servicing, result in expensive items of capital equipment being put out of action for comparatively long periods. Additionally, they occupy comparatively large areas of floor or bench space and a further disadvantage is that they sometimes incorporate overhead projectors and/or computers which provide an indication to the operative as to the positioning, in sequence, of the different components on the circuit boards as each component tray becomes accessible. Such projector/computer systems are also expensive to purchase, as well as maintain, and occupy extra space.

It is an object of the present invention to provide a container which can be used in electronic component assembly operations, which overcomes the operating disadvantages of the known assembly systems, and which encourages:

(1) low WIP levels;

(2) flexibility in the storage and accessability during assembly of components of different sizes;

(3) fast component changeover times;

(4) reduced throughput times;

(5) improved bonus incentive schemes;and

(6) reduced stock levels.

Accordingly, the invention provides a container for storing articles of different sizes, comprising a plurality of storage compartments, at least one adjacent pair of the compartments being separated by a divider which is moveable with respect to a main receptacle housing, whereby each of said at least one pair of adjacent compartments can be adjusted in size to accommodate articles of differing sizes.

Preferably, the receptacle housing is elongate has a generally U-shaped cross section, in which case, the cross section of each compartment divider is also semi-circular, with the dividers being adjustably moveable axially with respect to the housing. Each moveable divider can be fixed at any required position within the housing, once it has been moved with respect thereto to provide a suitably sized compartment on each side thereof.

The receptacle housing is preferably provided with a lid of which at least part is pivotable with respect to the housing to provide access to each compartment therein. Also, the or each divider may be provided with sealing means to prevent articles stored in each compartment from being transferred accidentally to another compartment and, in addition, the lid may also have sealing means which, when the lid is closed, retains any articles stored in the container in their respective compartments.

Furthermore, the invention can provide a container having two receptacle housings which are hinged together between open and closed positions, such that, in the closed position, the respective compartments are totally enclosed with their lids confronting each other. This provides a very suitable container for transportation purposes and, for this reason can be provided with a carrying handle.

In order that the invention may be more fully understood, preferred embodiments in accordance therewith, will now be described by way of example and with reference to the accompanying drawings in which:

Fig 1 is a persepective view from one end of an electronic component container having a single receptacle housing with adjustable compartment dividers and mounted for use upon a stand;

Fig 2 is an enlarged plan view of one end portion of the container of Fig 1, as indicated by the arrow II;

Fig 3 is a perspective view of another electronic component container having a pair of receptacle housings hinged together, in the closed position;

Fig 4 is a perspective view of the container shown in Fig 3 but in the open position and upon a stand ready for use;

Fig 5 is an end view of the mounted container shown in Fig 4; and

Fig 6 is a modification of the container shown in Figs 3 to 5.

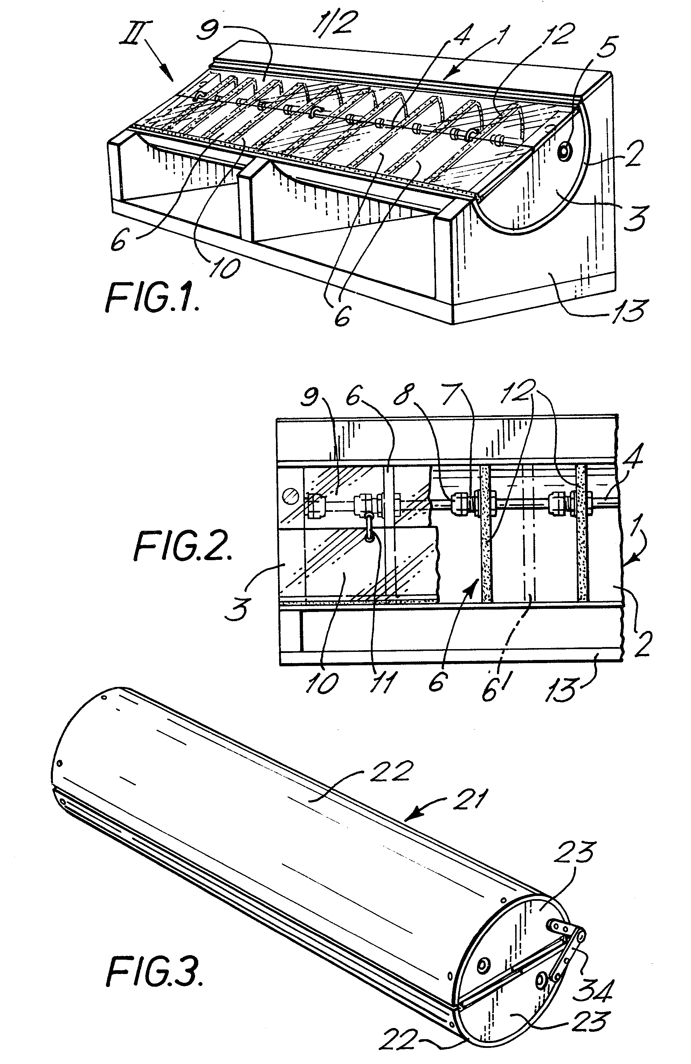

Referring firstly to the first embodiment of the invention, as shown in Figs 1 and 2, an electronic component container 1 comprises a receptacle housing 2 of semi-circular cross-section, which is closed at each end by a correspondingly - dimensioned semi-circular end wall 3. Between each end wall 3 of the receptacle housing 2, extends a rigid rod 4 of circular cross-section, the ends of the rod being located fixedly in holes 5 in respective end walls 3.

Slidably mounted upon the rod 4 is a plurality of dividers 6 which define respective compartments therebetween for receiving electronic components (not shown) to be assembled upon a printed circuit board (also not shown). Each of these dividers 6 can be located at a desired position along the length of the rod 4, such that adjacent pairs of dividers define therebetween a compartment of predetermined capacity for receiving a given number of electronic components of a certain size. The slidable adjustment of the dividers 6 with respect to the rigid rod 4 is shown clearly in Fig 2, wherein an alternative position for either of the two right hand dividers is shown in chain-dotted lines at 6'. Each divider 6 can be secured in the desired position upon the rod 4 by means of a locking arrangement comprising a threaded, split tube portion 7 which is fixed to the divider 6 and extends annularly and axially with respect to the rod 4 and upon which is threaded a tightening nut 8. When a divider 6 has been slid along the rod 4 to its desired position, the locking nut 8 is screwed on to the threaded, split tube portion 7, such that the latter clampingly engaged the rod 4.

The receptacle housing 2 is provided with a transparent, perspex lid of which a first part 9 is fixed and a second part 10 is pivotable with respect thereto between open and closed positions, by means of interconnecting hinge elements 11.

The confronting surfaces and/or edges of the receptacle housing 2, the compartment dividers 6 and the pivotable lid part 10 are sealed by means of plastics foam strip material 12 which closes any gaps between these components of the container 1 to prevent electronic components in one of the compartments from being transferred accidentally to another of the compartments during transit.

The container 1 is mounted upon a stand 13 such that its upper flat surface is inclined towards an operative who will be able to view the components in each compartment through the transparent lid parts 9,10. The inner arcuate surface of the receptacle housing 2 permits ready removal of components from their respective compartments, with the pivotable lid part 10 in its open position. Of course, it will be appreciated that the lid can be in one part which is pivotable with respect to the receptacle housing 2, rather than in two parts 9, 10, as shown in this particular embodiment.

Referring now to the second embodiment of the invention as shown in Figs 3 to 5, this electronic component container 21 comprises 2 receptacle housings 22 of semi-circular cross-section which are hinged together by means of a pair of hinge members 34 attached to respective pairs of end walls 23.

Each receptacle housing 22 is substantially identical to the container 1 having a single receptacle housing 2, described above with reference to Figs 1 and 2.

Once again, the container 21 is mounted upon a stand 33, with the upper face of each housing 22 inclined towards an operative position.

In this particular embodiment of double receptacle housing arrangement, both lid parts 30 are pivotable with respect to their associated fixed lid part 29 in the same direction, as indicated by the arrows 35, between their open and closed positions.

In the modified embodiment of Fig 6, the pivotable lid parts 40 are moveable in opposite directions, as indicated by the arrows 41,42, between their respective open and closed positions. Also, in this modified embodiment of container, the two receptacle housings 42 are mounted in the associated stand 43, such that the upper sides of the housings are inclined in opposite directions, whereby this arrangement can be used by two operatives in tandem, that is to say, facing each other.

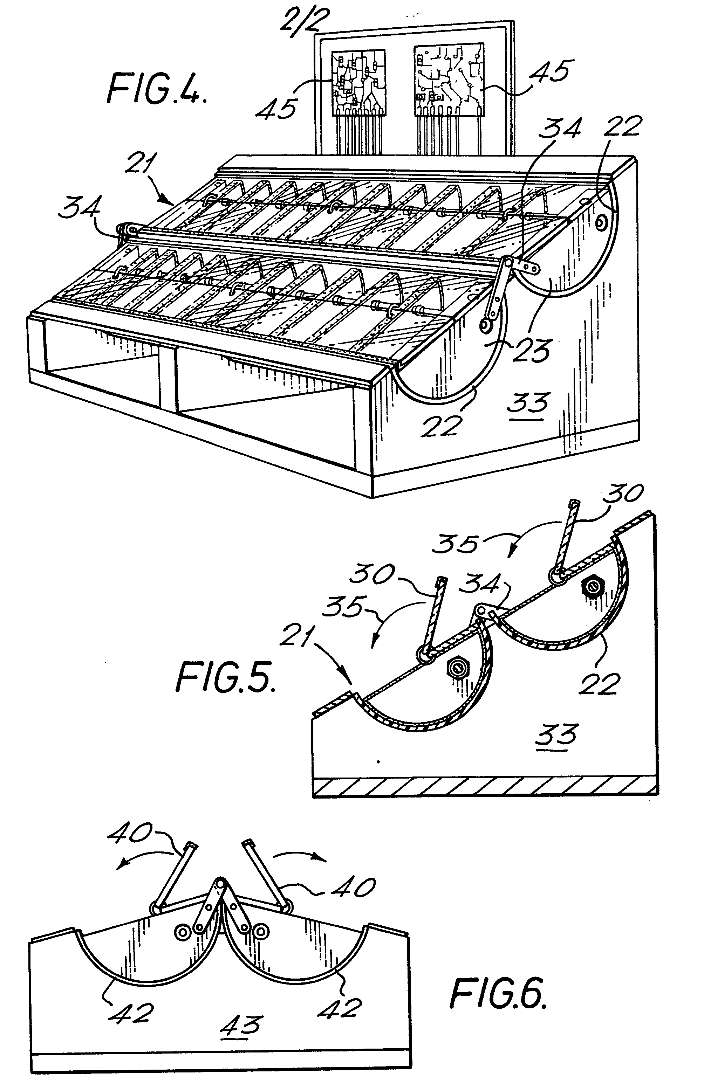

As shown in Fig 4, the stand 33 is provided with two assembly diagrams 45 which correspond to the circuit to be assembled from the electronic components in the respective compartments by an operative. A series of light emitting diodes (not shown) are housed in the stand 13 which supports the electronic component container 21 on a work bench and a further series of light emitting diodes (also not shown) are plugged in to corresponding positions on the assembly diagrams 45. As an operative assembles a circuit, moving from left to right along the compartments of the component container 21 or vice versa, the light emitting diode associated with each compartment is lit in turn, as is the corresponding diode on the diagram 45, the sequential operation of the light emitting diodes along the compartments being switch-operated by the operative.

Of course, it will be appreciated that this controlling arrangement can also be used with the embodiments of component container described with reference to Figs 1 and 2 and Fig 6.

By using the component containers in accordance with the invention, it is simple to ensure that:

(1) an operative is always presented with an identical array of electronic components each time a particular job is repeated, thus reducing refamiliarisation time;

(2) regardless of changing quantities, the operative is always presented with the correct component in the proper sequence, thus reducing risk of errors in assembly;

(3) each component is tested, inspected, formed or otherwise prepared for the precise position in which it is to be used, as a matter of routine, thereby minimising problems in the assembly shop, enhancing the possibility of the operative completing a particular job properly first time and reduction in quality control costs;

(4)    small batches of work can be issued to operatives, thus reducing WIP, facilitating short notice changes to production plans, controlling production, low volume non-flowline type production, eliminating shortages from the shop floor and providing an accurate method of accessing scrap material; and

(5)    where tandem working is employed, inspection is reduced and quality and quality control is improved, thereby providing the work in a balanced form.

Furthermore, although the preferred embodiment of the invention described above includes an arrangement whereby the dividers 6 are slidably mounted upon the rod 4 for location at a desired position along the length thereof, it should also be appreciated that any other suitable form of arrangement can be used. For example, each divider could be provided with means, such as, a projecting lug slidably engaged in a corresponding groove or channel in the inner surface of the receptacle housing. Preferably, this slidable engagement between the dividers and receptacle housing is frictional, whereby any locking arrangement, such as, the threaded, split tube portion 7 and associated tightening nut 8 can be eliminated. Alternatively, of course, a suitable form of locking arrangement could be provided, if necessary.

In addition, it is to be understood that the inventive container can be used for purposes other than that described above, for instance, for general storage purposes, particularly in the do-it-yourself field.

CLAIMS

1. A storage container (1) comprising a main receptacle housing (2) and a plurality of storage compartments defined therein, at least one pair of adjacent compartments being separated by a divider (6)
characterised in
that the or each divider (6) is movable with respect to the main receptacle housing (2), whereby each of said at least one pair of adjacent compartments is adjustable in size.

2. A storage container (1) according to claim 1, wherein the main receptacle housing (2) is elongate and generally U-shaped in cross-section and the or each divider (6) is correspondingly U-shaped and is adjustably movable axially with respect to the longitudinal axis of the housing (2).

3. A Storage container (1) according to claim 2, wherein the or each divider (6) is fixable at a required position along the length of the axis of the housing (2).

4. A storage container (1) according to claim 1,2 or 3, wherein the main receptacle housing (2) has a lid (9,10) of which at least part (10) is pivotable with respect to the housing (2) to provide access to at least one of the compartments.

5. A storage container (1) according to claim 4, wherein the lid (9,10) has sealing means (12) arranged to seal the compartments from each other, when in the closed position.

6. A storage container (1) according to claim 5, wherein the or each divider (6) has sealing means (12) arranged to seal further the compartments from each other.

7. A storage container according to any of claims 1 to 4, wherein the or each divider (6) has sealing means (12) arranged to seal the compartments from each other.

8. A storage container (21) according to any preceding claim comprising two of said main receptacle housings(22) which are hingeably connected together for pivotal movement with respect to each other between open and closed positions, whereby,in the closed position the compartments are substantially totally closed.

9. A storage container (21) according to claim 8, when dependent upon claim 4,5 or 6, wherein the respective lids (30;40) are in confronting relationship with each other when the two housings (22) are in the closed position.

10. A storage container (21) according to claim 8 or 9, wherein, in the open position, the main receptacle housings (22) can be supported upon a stand (33;43).

11. A storage container (1;21) according to any preceding claim, wherein the or each divider (6) is slidably mounted upon a rod (4) located within the or each main receptacle housing (2;22).

12. A storage container (1;21) according to claim 11, wherein the or each divider (6) is fixable in a desired position along the length of the rod (4) by means of a threaded, split tube portion (7), attached to the divider (6) and extending annularly and axially with respect to the rod (4), and a locking nut (8) threaded on to the tube portion (7), the arrangement being such that, when the or a divider (6) has been slid along the rod (4) to a desired position, the locking nut (8) can be screwed down on to the threaded, split tube portion (7) to clamp the same, and hence the divider (6), to the rod (4).

13. A storage container (1;21) according to any preceding claim, wherein the or each main receptacle housing (2;22),as the case may be, has an external carrying handle.

14. An electronic component assembly apparatus comprising a storage container (1;21) according to any preceding claim, an assembly diagram (45) corresponding to a circuit to be assembled from electronic components in respective compartments of the container (1;21), a stand (33,43) upon which the container (1;21) is supported, a series of indicators housed in the stand (33;43) and associated with respective compartments and a further series of indicators associated with corresponding positions for electronic components on the assembly diagram (45), the arrangement being such that the respective indicators associated with the compartments can be activated in turn and simultaneously with the corresponding indicators on the assembly diagram (45), thereby identifying the electronic components in the compartments with respective positions in the circuit on the assembly diagram (45).

15. An apparatus according to claim 14, wherein the indicators are visual indicators, preferably light emitting diodes.

0090519

FIG.1.

FIG.2.

FIG.3.

0090519

2/2

FIG.4.

FIG.5.

FIG.6.